**Europäisches Patentamt**

**European Patent Office**

**Office européen des brevets**

(11) Numéro de publication : **0 338 910 B1**

# FASCICULE DE BREVET EUROPEEN

(45) Date de publication du fascicule du brevet :
**19.11.92 Bulletin 92/47**

(51) Int. Cl.⁵ : **H01L 31/10,** H01L 31/02, H01L 31/18

(21) Numéro de dépôt : **89401061.0**

(22) Date de dépôt : **18.04.89**

(54) Photoconducteur en silicium amorphe à rendement quantique amélioré.

(30) Priorité : **19.04.88 FR 8805141**

(43) Date de publication de la demande :
**25.10.89 Bulletin 89/43**

(45) Mention de la délivrance du brevet :
**19.11.92 Bulletin 92/47**

(84) Etats contractants désignés :
**DE FR GB NL**

(56) Documents cités :
EP-A- 0 126 417
EP-A- 0 178 639
GB-A- 2 083 701
THE CONFERENCE RECORD OF THE 19TH
IEEE PHOTOVOLTAIC SPECIALISTS CONFE-
RENCE- 1987, New Oleans, Louisiana, 4-8 mai
1987, pages684-688, IEEE, New York, US; R.E.
HOLLINGSWORTH et al.: "Amorphous silicon
carbide solar cells"

(56) Documents cités :
PATENT ABSTRACTS OF JAPAN, vol. 9, no.
263 (E-351)[1986], 19 octobre 1985, page 52 E
351; & JP-A-60 109 273 (NIPPON DENKIK.K.)
14-06-1985
THIN SOLID FILMS, vol. 121, no. 3, novembre
1984, pages 233-246, Elsevier Sequoia, Lausanne, CH; P. CHAUDHURI et al.:"Properties
of undoped and p-type hydrogenated amorphous silicon carbide films"
SEMICONDUCTORS AND SEMIMETALS, vol.
11 (1975), Academic Press, pp. 24-37.

(73) Titulaire : **THOMSON-CSF**
**51, Esplanade du Général de Gaulle**
**F-92800 Puteaux (FR)**

(72) Inventeur : **Arques, Marc**
**THOMSON-CSF SCPI - Cedex 67**
**F-92045 Paris La Defense (FR)**
Inventeur : **Henry, Yves**
**THOMSON-CSF SCPI - Cedex 67**
**F-92045 Paris La Defense (FR)**

(74) Mandataire : **Guérin, Michel et al**
**THOMSON-CSF SCPI 51, Esplanade du**
**Général de Gaulle**
**F-92045 PARIS LA DEFENSE CEDEX 67 (FR)**

## Description

L'invention concerne les photodétecteurs, et plus particulièrement mais non exclusivement ceux qui sont réalisés à base de diodes PIN au silicium amorphe.

Dans une diode PIN, composée de trois couches superposées qui sont respectivement une couche de silicium amorphe dopée de type P, une couche de silicium amorphe intrinsèque ou très peu dopée, et une couche de silicium amorphe dopée de type N, la couche centrale intrinsèque est celle dans laquelle se produit essentiellement l'effet photoélectrique, c'est-à-dire la production d'un courant sous l'effet d'un éclairement.

En effet, les photons incidents engendrent des paires électrons-trous dans toutes les couches, mais d'une part c'est seulement dans la couche intrinsèque qu'il y a un champ électrique suffisant pour permettre d'établir un courant, et d'autre part c'est seulement dans la couche intrinsèque (du fait de son très faible dopage) qu'il y a un taux de recombinaison suffisamment faible pour que le courant ou les charges engendrées soit effectivement détectables.

Comme c'est la couche intrinsèque qui est donc la couche de détection utile, il est courant de prévoir des moyens pour réduire autant que possible l'absorbtion des photons dans la couche N ou la couche P (selon que c'est la couche N ou la couche P qui est traversée par le rayonnement incident). En effet, puisque ces couches ne participent pas vraiment à la production d'un courant mesurable, il ne faut pas qu'elles constituent un écran par rapport à la couche intrinsèque qui est la vraie couche photodétectrice de la structure.

Un moyen de réduction de l'absorbtion du rayonnement lumineux dans la couche N ou P consiste à doper cette couche avec du carbone. Ce dopage rend la couche plus transparente car il augmente le quantum d'énergie qu'on doit appliquer à une liaison interatomique pour briser cette liaison et engendrer une paire électron-trou. Ce quantum d'énergie sera appelé ci-après " gap " conformément à l'habitude; il est fonction du matériau semiconducteur utilisé ainsi que des matériaux avec lequel il est dopé.

On dope au carbone par exemple la couche P qui reçoit directement le rayonnement incident; son gap augmente et elle devient plus transparente car il devient plus difficile à un électron d'être éjecté de sa bande de valence sous l'action d'un photon; par contre la couche N n'a pas besoin d'être dopée au carbone puisqu'elle est de l'autre côté; et la couche intrinsèque ne doit pas être dopée au carbone puisqu'on souhaite qu'elle soit absorbante et que de nombreuses paires électrons-trous soient engendrées.

Dans des applications comme les piles solaires, destinées à fournir de l'énergie électrique en quantité aussi grande que possible sous l'effet d'un éclairement, on essaye par ailleurs de rendre la couche intrinsèque moins transparente par un dopage à l'aide d'un matériau qui tend à diminuer le gap du semiconducteur de la couche intrinsèque.

En diminuant le gap, on augmente la probabilité pour que tous les photons incidents engendrent une paire électron-trou, même s'ils sont de faible énergie (rouge ou infrarouge ). On augmente ainsi la sensibilité du photodétecteur. Pour une couche intrinsèque en silicium amorphe, le matériau de dopage tendant à diminuer le gap peut être du germanium.

Parfois, toujours dans les applications comme les piles solaires, on dope la zone intrinsèque du côté qui reçoit la lumière avec une impureté qui tend à augmenter le gap, de manière que les rayonnements de plus grande longueur d'onde passent à travers le silicium en n'étant pratiquement pas absorbés, alors que les plus courtes longueurs d'onde sont rapidement absorbées dès leur pénétration dans la zone intrinsèque. La zone intrinsèque peut en outre être dopée à l'arrière avec une impureté qui diminue le gap, pour renforcer l'absorbtion des plus courtes longueurs d'onde. Cela sert à mieux répartir dans toute l'épaisseur de la zone intrinsèque la production de paires électrons-trous. Un exemple en est donné dans le brevet EP-A-0178639. Bien entendu, ce type de dopage tendant à augmenter ou diminuer le gap n'a de sens que parce que l'énergie à absorber est dans une large gamme de longueurs d'onde.

Tout ceci est valable aussi pour des structures de photodiodes voisines, telles que par exemple des structures à cinq couches, de type NIPIN ou PINIP; toutefois, dans ces structures, les deux couches intrinsèques ne jouent pas des rôles identiques et l'une des deux est d'ailleurs nettement plus épaisse que l'autre : c'est celle qui joue le même rôle que la couche intrinsèque unique des diodes PIN; elle constitue la couche centrale, soumise à un champ électrique élevé, d'une diode PIN polarisée en inverse. L'autre couche intrinsèque est beaucoup plus mince, en outre elle joue un autre rôle car elle consitue la couche centrale d'une diode polarisée en direct; si elle est située du côté qui reçoit la lumière on a avantage à ce qu'elle soit aussi rendue plus transparente, par un dopage au carbone par exemple.

Tout ceci est encore valable pour des photodétecteurs qui ne sont pas des photodiodes mais dans lesquels la couche détectrice est encore une couche semiconductrice intrinsèque soumise à un champ électrique.

La présente invention résulte de l'observation inattendue que pour certaines applications, et plus précisément des applications où les photodétecteurs reçoivent ou doivent détecter une lumière dans une gamme de longueurs d'onde étroite et bien définie, on augmente la sensibilité des photodétecteurs, c'est-à-dire la quantité de charges électriques ou de courant émis en réponse à un flux lumineux donné, en dopant la couche intrinsèque semiconductrice avec un matériau tendant à augmenter le gap du semiconducteur. Autrement dit, on s'est aperçu qu'en dopant la couche intrinsèque avec un matériau qui habituellement a pour rôle de rendre le semiconducteur plus transparent à la lumière donc de diminuer la quantité de charges électriques créées, on aboutissait à augmenter cette quantité de charges et donc la sensibilité du photodétecteur.

Lorsque la couche intrinsèque est en silicium amorphe, un dopage au carbone de la couche intrinsèque s'avère particulièrement intéressant lorsqu'on veut détecter un rayonnement dans une gamme de longueurs d'onde étroite autour de 550 nanomètres (couleur verte). Mais on peut le faire aussi pour détecter un rayonnement bleu vers 420 nanomètres.

L'invention est particulièrement intéressante dans une application où le photodétecteur est associé à un scintillateur et reçoit du scintillateur un rayonnement dans une bande de longueurs d'onde très étroite (monochromatique ou quasi monochromatique) si cette longueur d'onde correspond à la gamme dans laquelle la sensibilité de la couche intrinsèque est effectivement augmentée par le dopage au carbone.

En radiologie en particulier, on utilise des scintillateurs à l'oxysulfure de gadolinium qui émettent un rayonnement monochromatique vert à 550 nanomètres; avec un photodétecteur dont la couche intrinsèque est en silicium amorphe hydrogéné dopé au carbone, on obtient une augmentation de rendement tout à fait appréciable, et de plus une diminution du courant d'obscurité, c'est-à-dire des charges engendrées par agitation thermique même quand le détecteur n'est pas éclairé. Il en est de même pour des scintillateurs à l'iodure de césium émettant un rayonnement monochromatique bleu à 420 nanomètres.

L'amélioration du rapport sensibilité/bruit est moindre mais existe quand même avec un dopage au carbone d'une couche intrinsèque de silicium amorphe lorsque le scintillateur est constitué d'oxyde d'yttrium (rayonnement rouge à 610 nanomètres).

L'invention n'est pas limitée à l'utilisation du carbone comme dopant et du silicium amorphe comme matériau semiconducteur de la couche intrinsèque: pour déterminer quels matériaux peuvent convenir, on va maintenant donner l'explication supposée du fait que l'on arrive à augmenter la sensibilité de la couche intrinsèque en la dopant avec un matériau qui a priori la rend plus transparente donc moins sensible. L'homme de l'art pourra en déduire par le même raisonnement quel sont les autres dopants possibles pour le silicium amorphe et quels dopants pourraient convenir pour d'autres semiconducteurs que le silicium.

Les explications sont données en référence aux figures annexées dans lesquels:

- la figure 1 représente le rendement quantique théorique (en traits pleins) et réel (en traits pointillés) de photodétection d'un semiconducteur;

- la figure 2 représente les courbes réelles pour un semiconducteur intrinsèque (silicium) non dopé et pour un semiconducteur intrinsèque dopé au carbone

Dans la théorie, le rendement quantique d'émission de charges en présence d'un rayonnement de longueur d'onde lambda est une constante au dessous d'une certaine longueur d'onde de coupure Lc qui ne dépend que du gap du semiconducteur et qui est inversement proportionnelle à ce gap; il chute ensuite rapidement pour des longueurs d'onde plus grandes.

Le rendement quantique est le nombre d'électrons émis par photon incident. Au dessous de Lc, le rapport entre le nombre d'électrons émis et le nombre de photons incidents est constant (par exemple 0,5). Au dessus de Lc, le rendement quantique chute fortement.

Pour le silicium amorphe, le rendement quantique théorique est constant jusqu'à une valeur de longueur d'onde Lc égale à 650 nanomètres environ. Puis il chute.

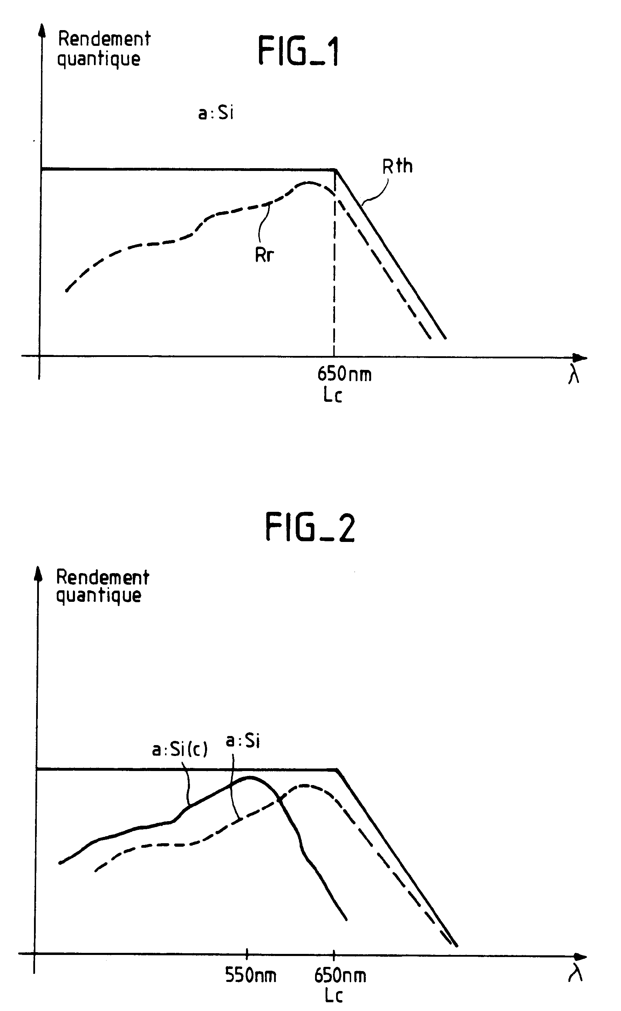

La courbe Rth de la figure 1, en traits pleins, représente ce rendement.

En fait, pour toutes sortes de raisons, le rendement réel d'un photodétecteur en électrons émis par photon n'est pas constant en fonction de la longueur d'onde au dessous de Lc. On constate que la courbe réelle Rr correspond plutôt à la forme tracée en pointillés sur la figure 1.

Cette forme présente plutôt un maximum pour la longueur d'onde Lc correspondant au gap du semiconducteur et elle décroît à la fois au dessus et au dessous de la longueur d'onde de coupure Lc.

En dopant le semiconducteur intrinsèque avec un matériau qui augmente le gap, on tend à reculer vers la gauche le maximum de la courbe Rr, puisqu'en augmentant le gap on diminue la longueur d'onde de coupure Lc pour laquelle dans la théorie (et d'ailleurs la réalité aussi) le rendement quantique se met à chuter fortement.

Toute l'astuce de l'invention consiste dans le choix d'un matériau de dopage de la couche intrinsèque en fonction de la longueur d'onde à détecter, ce matériau étant tel

- qu'il augmente le gap du semiconducteur au lieu de le diminuer comme on le faisait dans art antérieur,

- mais qu'il l'augmente dans une mesure calculée pour que le maximum de la courbe de rendement de photodétection se situe aux alentours de la gamme (étroite ou même monochromatique) de longueurs d'onde à détecter dans l'application considérée.

Pour un semiconducteur en silicium amorphe intrinsèque hydrogéné, la longueur d'onde de coupure est d'environ 650 nanomètres; le gap est de 1,6 à 1,7 électron-volt environ. Le dopage au carbone permet d'augmenter le gap du semiconducteur d'environ 0,4 électron-volt, ce qui a pour effet de décaler vers 550 nanomètres environ le maximum de la courbe du rendement quantique en fonction de la longueur d'onde.

Ce décalage est obtenu avec une concentration de carbone qui est celle obtenue au moment du dépôt du silicium intrinsèque amorphe par décomposition de silane en présence de méthane avec une proportion de méthane égale à environ 50 % du mélange gazeux.

La figure 2 représente ce décalage. Elle montre clairement que si on cherche à détecter un rayonnement monochromatique de longueur d'onde environ 550 nanomètres, la couche intrinsèque de silicium amorphe dopée au carbone sera meilleure qu'une couche de silicium non dopée au carbone, alors qu'elle est globalement plus transparente.

Par ailleurs, le courant d'obscurité du photodétecteur sera nettement diminué par cette augmentation du gap du semiconducteur.

L'invention s'applique tout particulièrement aux détecteurs de rayons X (radiologie) réalisés à partir de silicium amorphe hydrogéné et utilisant un scintillateur dont l'activateur est le gadolinium.

Dans un autre exemple, également applicable en radiologie, on cherche à détecter un rayonnement monochromatique bleu à 420 nanomètres. C'est le cas avec un scintillateur à l'iodure de césium.

On augmentera la dose de carbone incorporée au silicium amorphe intrinsèque de manière à déplacer vers la gauche jusqu'aux alentours de 420 nanomètres le maximum de la courbe de rendement quantique.

On y arrive par exemple en effectuant le dépôt de silicium intrinsèque par décomposition chimique de silane en présence de méthane, avec une proportion de méthane égale à environ 80 % 90 % du mélange gazeux (méthane + silane).

Pour vérifier par la mesure le déplacement du maximum de la courbe de rendement quantique, on utilise une source de lumière étalon (de spectre et d'intensité parfaitement connus) devant laquelle on place un monochromateur (à prisme ou à réseaux). Ce monochromateur permet de sélectionner une raie monochromatique donnée du spectre de la source et de faire varier cette raie.

Pour chaque raie on mesure le signal fourni par le détecteur éclairé par la source de lumière étalon à travers le monochromateur.

## Revendications

1. Détecteur comprenant un scintillateur pour convertir un rayonnement reçu en un autre rayonnement visible à bande de longueur d'onde étroite ou monochromatique, et comprenant en outre une couche photosensible principale détectant ce rayonnement visible, cette couche étant constituée par du silicium amorphe intrinsèque ou quasi- intrinsèque, caractérisé en ce que la couche intrinsèque est dopée avec du carbone de telle sorte que le silicium amorphe intrinsèque dopé avec ce matériau possède une courbe de rendement quantique en fonction de la longueur d'onde présentant un maximum aux environs de la bande de longueurs d'ondes visible émise par le scintillateur.

2. Détecteur selon la revendication 1, caractérisé en ce que le scintillateur est en oxysulfure de gadolinium émettant un rayonnement vert, et en ce que le semiconducteur intrinsèque est du silicium amorphe hydrogéné.

3. Détecteur selon la revendication 2, caractérisé en ce que la proportion de carbone dans le silicium amorphe intrinsèque est celle qui est obtenue par décomposition chimique en phase gazeuse de silane en présence de méthane avec une proportion de méthane d'environ 50 % du mélange.

4. Détecteur selon la revendication 1, caractérisé en ce que le scintillateur est en iodure de césium émettant un rayonnement bleu vers 420 nanomètres de longueur d'onde, et en ce que le semiconducteur intrinsèque est du silicium amorphe hydrogéné, la proportion de carbone dans le silicium étant celle obtenue à partir de la décomposition de silane en présence de méthane, la proportion de méthane étant d'environ 80 à 90 % du mélange.

## Patentansprüche

1. Detektor mit einem Scintillator zur Umwandlung einer empfangenen Strahlung in eine andere sichtbare Strahlung eines engen oder monochromatischen Wellenlängenbereichs, und außerdem mit einer lichtempfindlichen Hauptschicht, die dieses sichtbare Licht erfasst und aus amorphem, intrinsischem oder quasi-intrinsischem Silizium besteht, dadurch gekennzeichnet, daß die intrinsische Schicht mit Kohlenstoff so dotiert ist daß das intrinsische amorphe Silizium, das mit diesem Material dotiert ist, eine Abhängigkeit des Quantenwirkungsgrads von der Wellenlänge besitzt, die ein Maximum in der Nähe des sichtbaren Wellenlängenbands besitzt, das von dem Scintillator ausgeht.

2. Detektor nach Anspruch 1, dadurch gekennzeichnet daß der Scintillator auf der Basis von Gadolinium-Oxysulfid arbeitet und eine grüne Strahlung aussendet, und daß der intrinsische Halbleiter mit Wasserstoff versehenes amorphes Silizium ist.

3. Detektor nach Anspruch 2, dadurch gekennzeichnet. daß der Anteil an Kohlenstoff im intrinsischen amorphen Silizium derjenige ist, der durch chemischen Zerfall von Silan in der Gasphase in Gegenwart von Methan mit einem Methananteil von 50% an der Mischung erhalten wird.

4. Detektor nach Anspruch 1 dadurch gekennzeichnet, daß der Scintillator auf der Basis von Cäsiumjodid arbeitet und eine blaue Strahlung bei einer Wellenlänge von 420 nm aussendet, und daß der intrinsische Halbleiter amorphes mit Wasserstoff versehenes Silizium ist und der Kohlenstoffanteil im Silizium sich auf Grund eines Zerfalls von Silan in Gegenwart vom Methan ergibt, wobei der Methananteil etwa 80 bis 90 % der Mischung beträgt.

## Claims

1. A detector comprising a scintillator for converting a received radiation into another visible radiation having a small wavelength bandwidth or being monochromatic, and further comprising a photosensitive main layer detecting this visible radiation, this layer being constituted by intrinsic or quasi intrinsic amorphous silicium, characterized in that the intrinsic layer is doped with carbon in such a way that the intrinsic amorphous silicium doped with this material presents a curve of quantum efficiency as a function of the wavelength with a maximum in the range of the visible wavelength band emitted by the scintillator.

2. A detector according to claim 1, characterized in that the scintillator is a gadolinium oxisuphide scintillator emitting a green radiation, and that the intrinsic semiconductor is hydrogenized amorphous silicium.

3. A detector according to claim 2, characterized in that the carbon doping rate in the intrinsic amorphous silicium is obtained by a chemical decomposition of silane in the gaseous phase in the presence of methane, the methane rate being about 50% of the mixture.

4. A detector according to claim 1, characterized in that the scintillator is of the cesium iodide type emitting a blue radiation of about 420 nm wavelength, and that the intrinsic semiconductor is hydrogenized amorphous silicium, the carbon doping rate in the silicium being obtained from the decomposition of silane in the presence of methane, the methane rate being about 80 to 90% of the mixture.

# FIG_1

Rendement quantique

a:Si

Rth

Rr

650nm
Lc

λ

# FIG_2

Rendement quantique

a:Si(c)   a:Si

550nm   650nm
Lc

λ